# EUROPÄISCHE PATENTSCHRIFT

(11) **EP 3 648 911 B1**
(45) Veröffentlichungstag und Bekanntmachung des Hinweises auf die Patenterteilung: **16.06.2021**
(21) Anmeldenummer: 18746571.1
(22) Anmeldetag: 03.07.2018
(51) Int. Cl.: B21C 23/06, B21C 23/18

(54) **VERFAHREN ZUR HERSTELLUNG EINER KÜHLPLATTE**
METHOD FOR PRODUCING A COOLING PLATE
PROCÉDÉ DE FABRICATION D'UNE PLAQUE DE REFROIDISSEMENT

(30) Priorität: 07.07.2017 DE 102017006425; 02.07.2018 DE 102018005265
(43) Veröffentlichungstag der Anmeldung: 13.05.2020
(73) Patentinhaber: Holzhauer GmbH&Co. KG, 72517 Sigmaringendorf (DE)
(72) Erfinder: HOLZHAUER, Anton, 72517 Sigmaringendorf (DE); HOLZHAUER, Joachim, 72517 Sigmaringendorf (DE)
(74) Vertreter: Hering, Hartmut
(86) Internationale Anmeldenummer: PCT/EP2018/000336
(87) Internationale Veröffentlichungsnummer: WO 2019/007547

(56) Entgegenhaltungen:
- EP-A1- 2 944 395
- EP-A1- 3 117 953
- DE-A1-102013 104 630
- JP-A- 2010 129 774
- JP-A- 2012 199 324

## Beschreibung

Die Erfindung bezieht sich auf Verfahren zur Herstellung einer Kühlplatte aus Material mit sehr guter Wärmeleitfähigkeit, wie Kupfer, Aluminium, deren Legierungen oder dergleichen mit etwa senkrecht über eine Grundfläche vorstehenden Pins auf einer vom Kühlmittel überstrichenen Wirkfläche, wobei die Pins von einem im wesentlichen radial verlaufenden, ebenen Umfangsrand umgeben sind, wobei die Kühlplatte in einem Werkstück mittels Umformen eines Werkstücks hergestellt wird.

Derartige Kühlplatten kommen beispielsweise zur Anwendung bei Batteriekonstruktionen, Inverter, Brennstoffzellen, wärmeempfindlichen elektrischen oder elektronischen Bauelementen, wie Chips oder dergleichen.

Üblicherweise werden Kühlplatten der gattungsgemäßen Art mittels Schmieden oder spanabhebender Bearbeitung hergestellt, wobei meistens zusätzlich aufwändige Nachbearbeitungen erforderlich sind. Bisher sind derartige Kühlplatten in der Herstellung relativ teuer und meist fällt auch Abfall bei der Bearbeitung des Materials mit sehr guter Wärmeleitfähigkeit an, welches in den Gestehungskosten relativ teuer ist.

Aus DE 10 2015 120 835 A1 ist ein Herstellungsverfahren für Kühlplatten bekannt, bei dem ein Flachmaterial mittels Walzen bearbeitet wird. Hierbei ergeben sich unregelmäßig ausgeformte Pins, welche ausreichend beabstandet sein müssen, um weitgehend gleichlange Pins zu erstellen. Ferner sind aufwändige, insbesondere zeitaufwändige Nachbearbeitungen erforderlich. Daher erhält man eine kleinere Pindichte an der Wirkfläche und die Kühlwirkung ist vermindert.

Aus EP 3 117 953 A1 ist ein Verfahren der im Oberbegriff umrissenen Art bekannt. Hierbei werden mittels eines einzigen Stempels eine Außenauflagefläche und die Pins gleichzeitig ausgeformt.

Bei DE 10 2013 104 630 A1, EP 2 944 395 A1, JP 2010 129 774 und JP 2012-199324 werden die Pins mittels eines einzigen Stempels ausgeformt.

Die Erfindung zielt darauf ab, ein Verfahren zur Herstellung einer Kühlplatte der gattungsgemäßen Art bereitzustellen, welche sich kostengünstig darstellen lässt sowie materialsparend und Resourcen-schonend ist und eine äußerst effektive Kühlwirkung mit großer Pindichte an der Wirkflache hat.

Nach der Erfindung wird hierzu ein Verfahren zur Herstellung einer Kühlplatte aus Material mit sehr guter Wärmeleitfähigkeit, wie Kupfer, Aluminium, deren Legierung oder dgl. mit etwa senkrecht über eine Grundfläche vorstehenden Pins auf einer vom Kühlmittel überstrichenen Wirkfläche, wobei die Pins von einem im wesentlichen radial verlaufenden, ebenen funktionsnotwendigen Umfangsrand umgeben sind, und die Kühlplatte in einem Werkzeug mittels Umformen eines Werkstücks hergestellt wird, wobei das Werkstück in Form eines Flachmaterialzuschnitts mit einheitlicher Materialdicke exakt zentriert in das Werkzeug eingelegt wird, welches sich dadurch auszeichnet dass das Werkzeug wenigstens einen Außenstempel (Umfangsrandstempel) zur Erzeugung des im wesentlichen ebenen Umfangsrandes umfasst und einen mit Pinausformöffnungen im Werkzeug zusammenarbeitenden Innenstempel (Pinstempel) zur Erzeugung der Pins umfasst, dass bei durch den Innenstempel niedergehaltenem Werkstück durch Pressen mittels des Außenstempels der Umfangsrand mit verminderter Materialdicke ausgeformt wird, und dass dann bei niedergehaltenem Außenstempel mittels des Innenstempels durch Pressen die Pins im Zusammenwirken mit den Pinausformöffnungen des Werkzeugs ausgeformt werden.

Bei der Erfindung kommt somit ein kostengünstiges Kaltpressen oder ein Pressen mit Erwärmung zum Einsatz, und bei der Ausbildung der Pins auf der vom Kühlmittel überstrichenen Wirkfläche das Material des Flachmaterialzuschnitts unmittelbar durch Umformen genutzt, so dass mit der erfindungsgemäßen Herstellung im wesentlichen kein Materialverlust und Materialabfall anfällt, und es sich um eine materialsparende und Resourcenschonende Herstellungsweise handelt. Ferner ist der beim erfindungsgemäßen Verfahren erzeugte Materialüberstand über jenem Flächenbereich des Werkstücks vorhanden, an welchem bei der Herstellung der Kühlplatte auf der Wirkfläche die Pins ausgeformt werden. Die Restfläche des Flachmaterialzuschnitts bleibt bei der Pinausformung unverformt und bietet daher passende Auflageflächen für Dichtungen beispielsweise, ohne dass es noch einer zusätzlichen Nachbearbeitung bedarf. Beim erfindungsgemäßen Verfahren erfolgt in einer einzigen Umformbearbeitung einerseits die Ausformung des im wesentlichen ebenen, funktionsnotwendigen Umfangsrandes mittels des zugeordneten Umfangsrandstempels (Außenstempels) und andererseits die Ausformung der Pins mittels des Innenstempels (Pinstempels) im Zusammenwirken mit den Pinausformöffnungen im Werkzeug.

Vorzugsweise werden mittels einer Auswurfeinrichtung wenigstens einige der dem Umfangrand benachbarten Pinausformöffnungen des Werkzeugs vor und um eine Pinlänge versetzt beim Ausformen des Umfangsrandes mittels des Außenstempels verschlossen.

Vorzugsweise werden beim erfindungsgemäßen Verfahren die Pins ausgehend von ihren feien Enden kalibriert. Beim Kalibrieren sind die freien Enden der Pins eben gepresst oder aufgestaucht. Ferner kann bei der Kalibrierung der Pins auch eine gegenkonische Ausbildung erzeugt werden, wenn ausgehend von den freien Enden der Pins eine solche Kalibrierung erfolgt, dass der Durchmesser der Pins ausgehend vom freien Ende in Richtung der Fußfläche kleiner wird.

Alternativ kann mittels der Kalibrierung auch eine konische Ausbildung vorgesehen werden, wenn ausgehend von den freien Enden der Pins eine solche Kalibrierung erfolgt, dass der Durchmesser der Pins ausgehend von den freien Enden in Richtung der Fußfläche größer wird.

Zweckmäßigerweise ist der Flachmaterialzuschnitt viereckförmig ausgebildet. Insbesondere kann es sich um einen rechteckförmigen Flachmaterialzuschnitt handeln.

Vorzugsweise wird der Flachmaterialzuschnitt von gewalztem oder gepresstem Material, insbesondere von gewalztem Kupfer gebildet.

Zusammenfassend ist es beim erfindungsgemäßen Verfahren wesentlich, dass die Kühlplatten mit den Pins ausschließlich durch Umformung hergestellt werden.

Weitere Einzelheiten, Merkmale und Vorteile der Erfindung ergeben sich aus der nachstehenden Beschreibung von bevorzugten Ausführungsbeispielen ohne beschränkenden Charakter unter Bezugnahme auf die beigefügte Zeichnung. Darin gilt:
- Fig. 1: eine schematische Schnittansicht eines Anwendungsbeispiels einer Kühlplatte nach der Erfindung;
- Fig. 2 bis 7: schematische perspektivische Teilschnittansichten zur Verdeutlichung des Verfahrensablaufs bei dem Herstellungsverfahren einer Kühlplatte nach der Erfindung;
- Fig. 8 und Fig. 9: sind Ausschnittsvergrößerungen einzelner Pins der in Fig. 7 gezeigten Kühlplatte, und
- Fig. 10 bis 12: schließlich zeigen schematisch als Beispiele weitere Ausgestaltungsformen der Pins.

In den Figuren der Zeichnung sind gleiche oder ähnliche Teile mit denselben Bezugszeichen versehen.

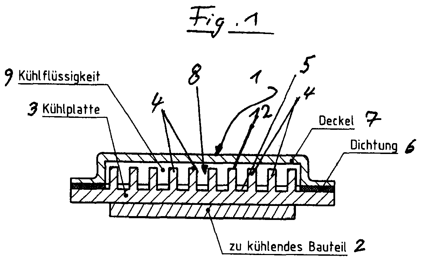

In Fig. 1 ist schematisch ein Anwendungsbeispiel für ein insgesamt mit 1 bezeichnete Kühlanordnung gezeigt. An einem zu kühlenden Bauteil 2, wie ein elektrisches oder elektronisches Bauteil, ist eine Kühlplatte 3 mit der den Pins gegenüberliegenden Fläche angebracht. Wie gezeigt, umfasst die Kühlplatte 3 Pins 4 auf einer vom Kühlmittel überstrichenen Wirkfläche 5. Mittels einer Dichtung 6 ist bei dem dargestellten Beispiel ein Deckel 7 fluiddicht mit dem im wesentlichen radial verlaufenden, ebenen Umfangsrand W, welcher die Pins 4 umgibt, derart verbunden, dass sich zwischen dem Deckel 7 und den Pins 4 der Kühlplatte 3 ein Zwischenraum 8 bildet, welcher von einem Kühlmittel 9, wie Kühlflüssigkeit oder Kühlfluid durchströmt wird.

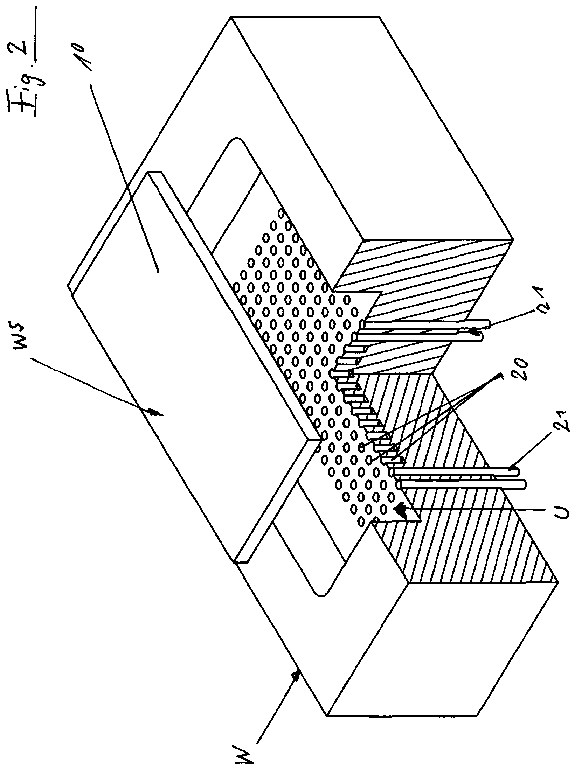

Anhand den Figuren 2 bis 7 wird der erfindungsgemäße Verfahrensablauf zur Herstellung einer Kühlplatte aus Material mit sehr guter Wärmeleitfähigkeit näher erläutert.

In Fig. 2 ist schematisch in Teilschnittdarstellung ein Werkzeug W dargestellt, welches am Boden viele Ausformöffnungen 20 hat. Mittels einer Auswurfeinrichtung sind wenigstens einige der dem Umfangsrand U benachbarten Ausformöffnungen 20 verschlossen. Beabstandet zum Werkzeug W ist schematisch ein Werkstück WS in Form eines Flachmaterialzuschnitts als Rohteil 10 angedeutet. Dieses Werkstück WS hat in der Fig.2 eine einheitliche oder gleich große Materialdicke.

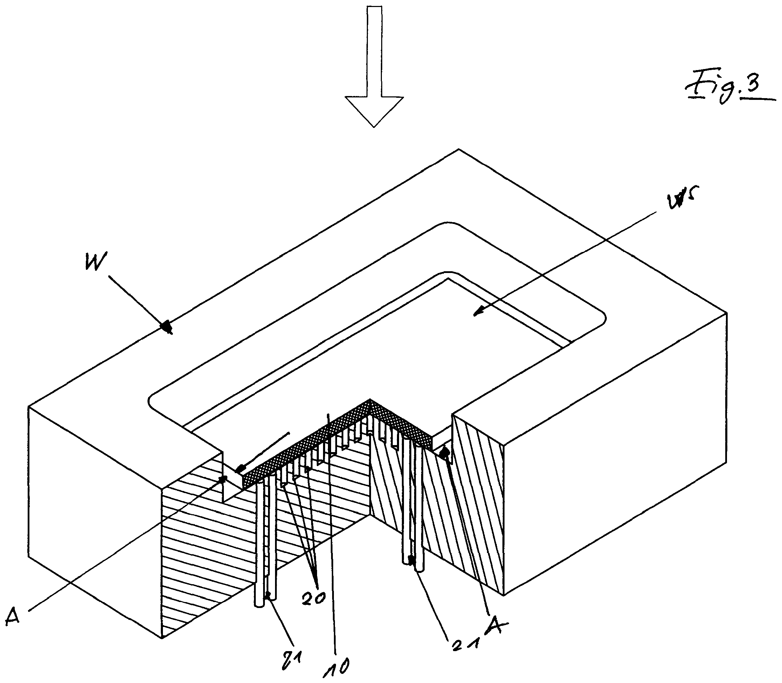

Wie in Fig. 3 verdeutlicht, wird das Werkstück WS oder der Flachmaterialzuschnitt 10 genau zentriert in das Werkzeug W auf dessen Boden aufliegend eingelegt. Wie aus Fig. 3 zu ersehen ist, ist der Flachmaterialzuschnitt 10 derart im Werkzeug W angeordnet, dass zwischen den seitlichen Begrenzungen des Werkzeugs W und dem Außenumfang des Flachmaterialzuschnitts 10 in Umfangsrichtung ein vorbestimmter Abstand A eingehalten wird.

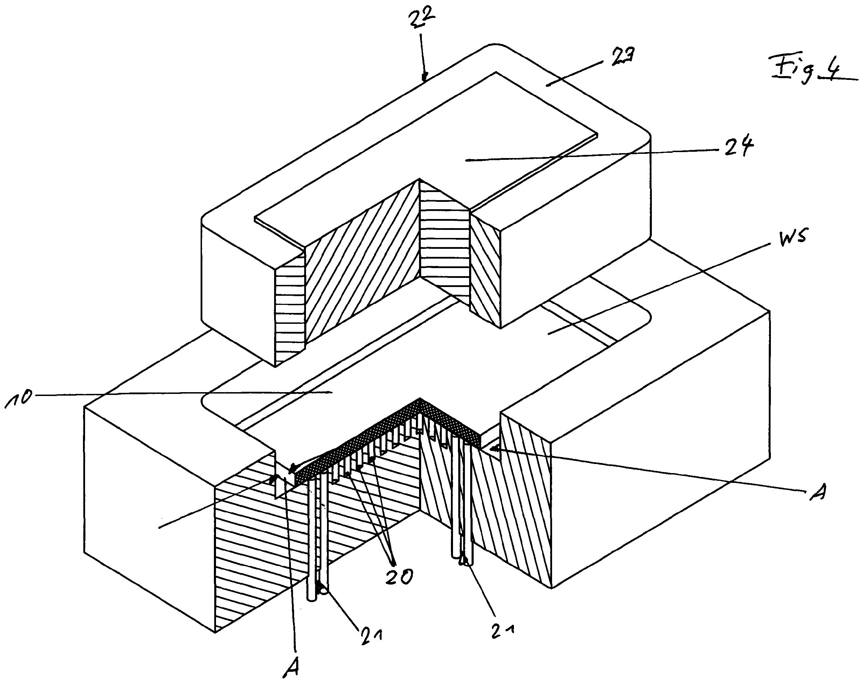

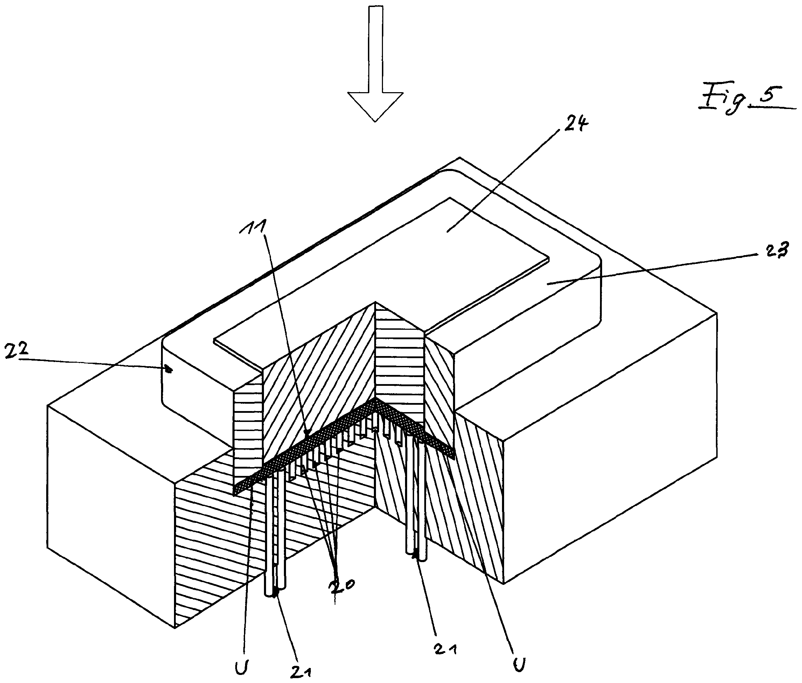

In Fig. 4 ist schematisch in Teilschnittdarstellung eine insgesamt mit 22 bezeichnete Stempelanordnung gezeigt. Diese Stempelanordnung 22 umfasst wenigstens einen Außenstempel bzw. Umfangsrandstempel 23 und einen Innenstempel bzw. Pinstempel 24. Diese Stempelanordnung 22 wird gemäß Fig. 5 derart auf den Flachmaterialzuschnitt 10 bewegt, dass bei durch den Innenstempel 24 niedergehaltenem Werkstück WS bzw. 10 mittels des Außenstempels 23 durch Pressen der Umfangsrand U mit verminderter Materialdicke ausgeformt wird. Hierdurch bildet sich im Vergleich zu Fig. 4 gegenüber dem ausgeformten Umfangsrand U im Werkstück WS ein Materialüberstand 11. Wie ferner aus den Fig. 4 und 5 zu ersehen ist, verschließen in bevorzugter Weise Teile der Auswurfeinrichtung 21 wenigstens einige der dem Umfangsrand U benachbarten Pinausformöffnungen 20. Hierdurch kann wirksam verhindert werden, dass bei der Pressbearbeitung zur Ausformung des Umfangsrandes U auch Material des Werkstücks WS in die Ausformöffnungen 20 gelangt.

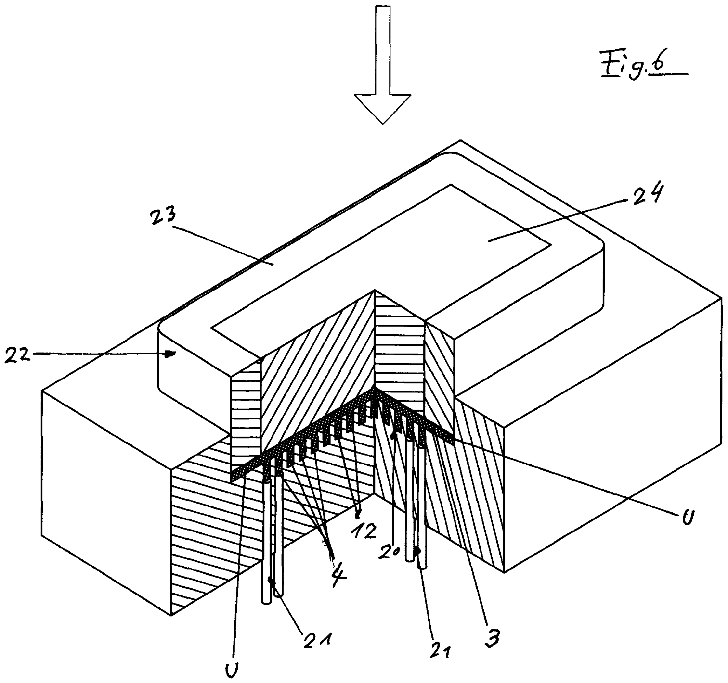

Bei der Darstellung nach Fig. 6 wird schematisch der Bearbeitungsvorgang erläutert, bei dem bei niedergehaltenem Außenstempel 23 mittels des Innenstempels 24 durch Pressen die Pins 4 im Zusammenwirken mit den Pinausformöffnungen 20 ausgeformt werden. Wie aus Fig. 6 zu ersehen ist, hat die fertiggestellte Kühlplatte 3 eine durchgehende Grundfläche von Umfangsrand U und dem restlichen Teil der Kühlplatte 3 mit den Pins 4. Die Materialdicke der Grundfläche der Kühlplatte 3 ist im wesentlichen gleichgroß wie am Umfangsrand U.

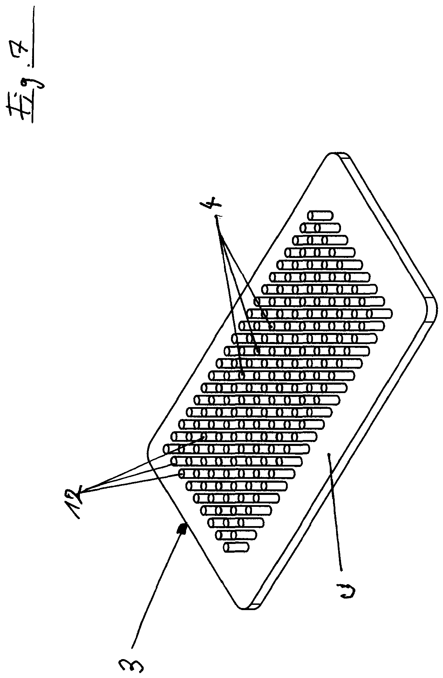

In Fig. 7 ist schematisch in einer perspektivischer Ansicht eine Kühlplatte 3 mit sehr eng aneinander liegenden Pins 4 auf der Wirkfläche 5 verdeutlicht. Der Umfangsrand U umgibt die Pins 4 und bildet eine gemeinsame Grundfläche mit dem Fußbereich der Pins 4.

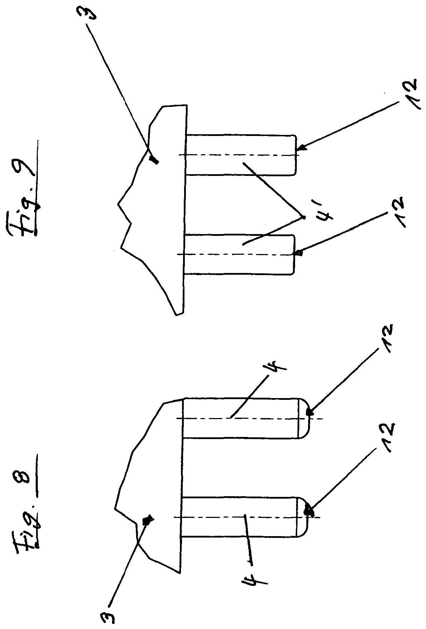

In Fig. 8 sind in schematischer, vergrößerter Darstellung zwei Pins gezeigt, deren Ausformung, wie in Fig. 5 und 6 verdeutlicht, durch das Zusammenwirken des Innenstempels 24 durch einen Pressvorgang im Zusammenwirken mit den Pinnausformöffnungen 20 gebildet werden. In Fig. 9 ist die Kühlplatte 3 nach einer Kalibrierungsbehandlung mit den Pins 4' verdeutlicht. Wie aus den Fig. 8 und 9 zu ersehen ist, haben die Pins 4, 4' nach der Ausformung bei der Umformung nach Fig. 6 freie Enden 12, welche geringfügig nach außen gewölbt sind. Bei der Kalibrierung nach Fig. 9 sind diese freien Enden 12 eben gepresst worden, oder können auch aufgestaucht sein.

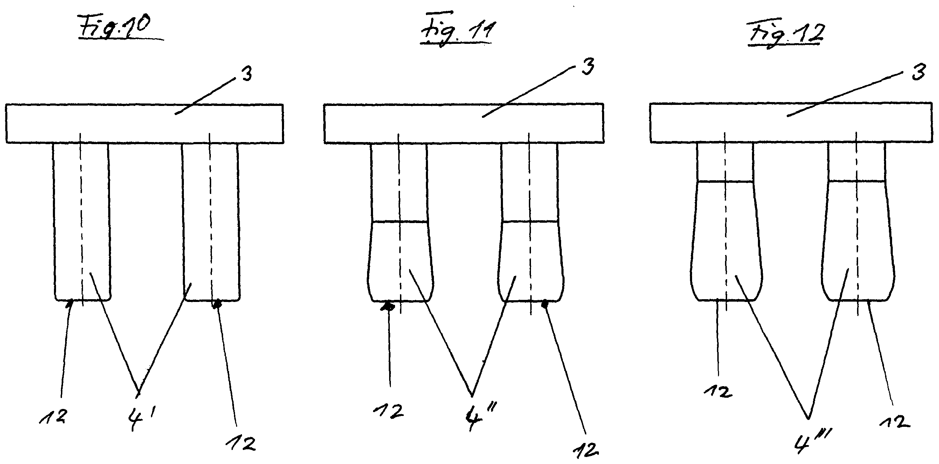

Anhand den Fig. 10 bis 12 schließlich werden schematisch weitere Ausführungsbeispiele von Ausgestaltungsformen der Pins 4 gezeigt.

Fig. 10 zeigt zylindrisch ausgebildete Pins 4'. In Fig. 11 ist als Beispiel eine gegenkonische Ausbildung von Pins 4" verdeutlicht, welche sich aber nur in etwa über die Hälfte der Höhe des jeweiligen Pins 4" erstreckt. Bei einer solchen gegenkonischen Ausbildung erfolgt ausgehend von den freien Enden der Pins 4" eine solche Kalibrierung, dass der Durchmesser der Pins 4" ausgehend vom freien Ende 12 in Richtung der Fußfläche kleiner wird.

Auch in Fig. 12 ist ein Beispiel einer solchen gegenkonischen Ausbildung von Pins 4"' verdeutlicht. Hierbei reicht die gegenkonische Ausbildung bis nahezu zum Fußbereich der Pins 4"'. Alternativ können die Pins 4 insgesamt konisch oder teilkonisch ausgebildet werden. Dies wird mit Hilfe einer entsprechenden Kalibrierungsbehandlung erreicht. Bei einem solchen Fall erfolgt ausgehend von den freien Enden 12 der Pins 4 eine solche Kalibrierung, dass der Durchmesser der Pins 4 ausgehend vom freien Ende in Richtung der Fußfläche größer wird.

Die Erfindung ist natürlich nicht auf die dargestellten Ausführungsbeispiele beschränkt, sondern es sind zahlreiche Abänderungen und Modifikationen möglich, die der Fachmann im Bedarfsfall treffen wird, ohne den Erfindungsgedanken zu verlassen. Insbesondere können die Pins 4, 4', 4", 4'" in Abhängigkeit von dem jeweiligen Anwendungsbereich durch Kalibrierung auch von den dargestellten Ausführungsbeispielen abweichende Ausgestaltungsformen haben, oder auch Kombinationen der in den Figuren 9 bis 12 gezeigten Ausführungsbeispiele umfassen. Obgleich in den dargestellten Beispielen von einem rechteckförmigen Flachmaterialzuschnitt 10 ausgegangen wird, kann dieser natürlich auch allgemein viereckförmig oder oval oder dergleichen ausgebildet sein, und es kann sich auch um einen Flachmaterialzuschnitt von quadratischer Gestalt handeln.

Vorzugsweise kann der Flachmaterialzuschnitt von gewalztem oder gepresstem Material, insbesondere von gewalztem Kupfer, gebildet werden. Hierbei handelt es sich um ein Material mit sehr guter Wärmeleitfähigkeit.

### Bezugszeichenliste

- 1: Kühlanordnung insgesamt
- 2: zu kühlendes Bauteil
- 3: Kühlplatte
- 4: Pins in Fig. 8
- 4': Pins in Fig. 9 + 10
- 4": Pins in Fig. 11
- 4"': Pins in Fig. 12
- 5: Wirkfläche
- 6: Dichtung
- 7: Deckel
- 8: Zwischenraum
- 9: Kühlmittel
- 10: Flachmaterialzuschnitt als Rohteil oder Werkstück WS
- 11: Materialüberstand
- 12: freies Ende von Pin 4

- 20: Pinausformöffnungen
- 21: Auswurfeinrichtung
- 22: Stempelanordnung insgesamt
- 23: Außenstempel
- 24: Innenstempel

- A: Abstand
- U: Umfangsrand
- W: Werkzeug
- WS: Werkstück

## Patentansprüche

1. Verfahren zur Herstellung einer Kühlplatte aus Material mit sehr guter Wärmeleitfähigkeit, wie Kupfer, Aluminium, oder deren Legierung mit etwa senkrecht über eine Grundfläche vorstehenden Pins (4, 4', 4", 4"') auf einer vom Kühlmittel überstrichenen Wirkfläche (5), wobei die Pins (4, 4', 4", 4'") von einem im wesentlichen radial verlaufenden, ebenen, funktionsnotwendigen Umfangsrand (U) umgeben sind, und die Kühlplatte (3) in einem Werkzeug (W) mittels Umformen eines Werkstücks (WS) hergestellt wird, **wobei** das Werkstück (WS) in Form eines Flachmaterialzuschnitts (10) mit einheitlicher Materialdicke exakt zentriert in das Werkzeug (W) eingelegt wird, **dadurch gekennzeichnet dass** das Werkzeug (W) wenigstens einen Außenstempel (23) zur Erzeugung des im wesentlichen ebenen Umfangsrandes (U) umfasst und einen mit Pinausformöffnungen (20) im Werkzeug zusammenarbeitenden Innenstempel (24) zur Erzeugung der Pins (4, 4', 4", 4"') umfasst, dass bei durch einen Innenstempel (24) niedergehaltenem Werkstück (WS) durch Pressen mittels des Außenstempels (23) der Umfangsrand (U) mit verminderter Materialdicke ausgeformt wird, und dass dann bei niedergehaltenem Außenstempel (23) mittels des Innenstempels (24) durch Pressen die Pins (4, 4', 4", 4"') im Zusammenwirken mit den Pinausformöffnungen (20) des Werkzeugs (W) ausgeformt werden.

2. Verfahren nach Anspruch 1, **dadurch gekennzeichnet, dass** mittels einer Auswurfeinrichtung (21) wenigstens einige der dem Umfangsrand (U) und benachbarten Pinausformöffnungen (20) des Werkzeugs (W) vor und um eine Pinlänge versetzt beim Ausformen des Umfangsrandes (U) mittels des Außenstempels (23) verschlossen werden.

3. Verfahren nach Anspruch 1 oder 2, **dadurch gekennzeichnet, dass** die Pins (4, 4', 4", 4'") ausgehend von ihren freien Enden (12) kalibriert werden.

4. Verfahren nach Anspruch 3, **dadurch gekennzeichnet, dass** beim Kalibrieren die freien Enden (12) der Pins (4, 4', 4", 4"') eben gepresst oder aufgestaucht werden.

5. Verfahren nach Anspruch 3 oder 4, **dadurch gekennzeichnet, dass** ausgehend von den freien Enden (12) der Pins (4') eine solche Kalibrierung erfolgt, dass der Durchmesser der Pins (4", 4"') ausgehend vom freien Ende in Richtung der Fußfläche kleiner wird, wobei eine gegenkonische Ausbildung erzeugt wird.

6. Verfahren nach Anspruch 3 oder 4, **dadurch gekennzeichnet, dass** ausgehend von den freien Enden (12) der Pins (4') eine solche Kalibrierung erfolgt, dass der Durchmesser der Pins ausgehend vom freien Ende in Richtung der Fußfläche größer wird, wobei eine konische Ausbildung erzeugt wird.

7. Verfahren nach einem der vorangehenden Ansprüche, **dadurch gekennzeichnet, dass** der Flachmaterialzuschnitt (10) viereckförmig ausgebildet ist.

8. Verfahren nach Anspruch 7, **dadurch gekennzeichnet, dass** der Flachmaterialzuschnitt (10) rechteckförmig ausgebildet ist.

9. Verfahren nach einem der vorangehenden Ansprüche, **dadurch gekennzeichnet, dass** der Flachmaterialzuschnitt (10) von gewalztem oder gepresstem Material, vorzugsweise von gewalztem Kupfer, gebildet wird.

## Claims

1. A method for producing a cooling plate made of material with very good thermal conductivity, such as copper, aluminium, or alloy thereof, with pins (4, 4', 4", 4"') protruding approximately perpendicular over a base on a coolant-swept effective surface (5), wherein the pins (4, 4', 4", 4'") are surrounded by a peripheral edge (U) running substantially radial and flat and which is necessary for operation, and the cooling plate (3) is produced in a tool (W) by means of shaping a workpiece (WS), **wherein** the workpiece (WS) in the form of a flat material blank (10) with a uniform material thickness is placed exactly centred in the tool (W), **characterised in that** the tool (W) comprises at least one outer punch (23) for producing the substantially flat peripheral edge (U) and an inner punch (24) cooperating with pin-forming openings (20) in the tool for producing the pins (4, 4', 4", 4'"), that the outer peripheral edge (U) is pushed out with reduced material thickness when a workpiece (WS) is held down by an inner punch (24) by pressing by means of the outer punch (23), and then, in cooperation with the pin-forming openings (20) of the tool (W), the pins (4, 4', 4", 4"') are pushed out when the outer punch (23) is held down by means of the inner punch (24) by pressing.

2. The method according to claim 1, **characterised in that,** by means of an ejection device (21), at least some of the pin forming openings (20) of the tool (W) adjacent to the peripheral edge (U) and offset from same by a pin length are closed off when forming the peripheral edge (U) by means of the outer punch.

3. The method according to claim 1 or 2, **characterised in that** the pins (4, 4', 4", 4"') are calibrated starting from their free ends (12).

4. The method according to claim 3, **characterised in that,** during calibration, the free ends (12) of the pins (4, 4', 4", 4"') are pressed flat or upset.

5. The method according to claim 3 or 4, **characterised in that,** proceeding from the free ends (12) of the pins (4'), a calibration takes place such that, starting from the free end in direction of the foot area, the diameter of the pins (4", 4"') becomes smaller, wherein a counter-conical configuration is produced.

6. The method according to claim 3 or 4, **characterised in that,** proceeding from the free ends (12) of the pins (4'), a calibration takes place such that, starting from the free end in direction of the foot area, the diameter of the pins becomes greater, wherein a conical configuration is produced.

7. The method according to one of the preceding claims, **characterised in that** the flat material blank (10) has a square configuration.

8. The method according to claim 7, **characterised in that** the flat material blank (10) has a rectangular configuration.

9. The method according to claim 7, **characterised in that** the flat material blank (10) is formed from rolled or pressed material, preferably from rolled copper.

## Revendications

1. Procédé de fabrication d'une plaque de refroidissement en un matériau avec une très bonne conductivité thermique, tel que le cuivre, l'aluminium ou leur alliage avec des broches (4, 4', 4", 4"') saillant à peu près verticalement d'une surface de base sur une surface active (5) balayée par le liquide de refroidissement, les broches (4, 4', 4", 4"') étant entourés par un bord périphérique plat (U), nécessaire au fonctionnement, qui s'étend sensiblement radialement et la plaque de refroidissement (3) étant fabriquée dans un outil (W) par mise en forme d'une pièce (WS), pour cela, la pièce (WS) sous la forme d'un flan découpé de matériau plat (10) d'une épaisseur de matériau uniforme étant insérée dans l'outil (W) de manière exactement centrée, **caractérisé en ce que** l'outil (W) comprend au moins un poinçon extérieur (23) pour produire le bord périphérique (U) sensiblement plat et un poinçon intérieur (24) coopérant avec des ouvertures de démoulage de broches (20) pour produire les broches (4, 4', 4", 4"'), **en ce qu'**à pièce (WS) maintenue enfoncée par un poinçon intérieur (24), le bord périphérique (U) est formé par pressage au moyen du poinçon extérieur (23) avec une épaisseur de matériau réduite, et **en ce qu'**ensuite, à poinçon extérieur (23) maintenu enfoncé, les broches (4, 4', 4", 4"') sont formées par pressage en coopération avec les ouvertures de démoulage de broches (20) de l'outil (W).

2. Procédé suivant la revendication 1, **caractérisé en ce qu'**au moins quelques-unes des ouvertures de démoulage de broches (20) de l'outil (W) voisines du bord périphérique (U) et décalées vers l'avant et d'une longueur de broche sont fermées au moyen du poinçon extérieur (23) lors du démoulage du bord périphérique (U).

3. Procédé suivant la revendication 1 ou 2, **caractérisé en ce que** les broches (4, 4', 4", 4'") sont calibrées à partir de leurs extrémités libres (12).

4. Procédé suivant la revendication 3, **caractérisé en ce que** les extrémités libres (12) des broches (4, 4', 4", 4"') sont pressées planes ou refoulées.

5. Procédé suivant la revendication 3 ou 4, **caractérisé en ce qu'**un calibrage a lieu à partir des extrémités libres (12) des broches (4') de telle sorte que le diamètre des broches (4", 4"') diminue à partir de l'extrémité libre en direction de l'embase du pied créant, ainsi, une conception conique inverse.

6. Procédé suivant la revendication 3 ou 4, **caractérisé en ce qu'**un calibrage a lieu à partir des extrémités libres (12) des broches (4') de telle sorte que le diamètre des broches augmente à partir de l'extrémité libre en direction de l'embase du pied créant, ainsi, une conception conique.

7. Procédé suivant une des revendications précédentes, **caractérisé en ce que** le matériau plat découpé (10) présente une conception de forme carrée.

8. Procédé suivant la revendication 7, **caractérisé en ce que** la découpe de matériau plat (10) présente une conception de forme rectangulaire.

9. Procédé suivant une des revendications précédentes, **caractérisé en ce que** la découpe de matériau plat (10) est formée par un matériau laminé ou pressé, de préférence par du cuivre laminé.
